Europäisches Patentamt

(19) European Patent Office

Office européen des brevets

(11) Veröffentlichungsnummer: **0 033 565**
**B1**

(12) **EUROPÄISCHE PATENTSCHRIFT**

(45) Veröffentlichungstag der Patentschrift:
**14.03.84**

(51) Int. Cl.³: **H 04 B 12/04**

(21) Anmeldenummer: **81200077.6**

(22) Anmeldetag: **22.01.81**

(54) **Adaptiver Deltamodulator.**

(30) Priorität: **29.01.80 DE 3002960**

(43) Veröffentlichungstag der Anmeldung:
**12.08.81 Patentblatt 81/32**

(45) Bekanntmachung des Hinweises auf die Patenterteilung:
**14.03.84 Patentblatt 84/11**

(84) Benannte Vertragsstaaten:
**BE CH DE FR GB IT LI NL SE**

(56) Entgegenhaltungen:
**EP - A - 0 003 009**
**FR - A - 2 189 941**
**US - A - 4 142 066**

(73) Patentinhaber: **Felten & Guilleaume Fernmeldeanlagen GmbH, Thurn-und-Taxis-Strasse 10 Postfach 4943, D-8500 Nürnberg 10 (DE)**

(84) Benannte Vertragsstaaten: **DE**

(73) Patentinhaber: **N.V. Philips' Gloeilampenfabrieken, Groenewoudseweg 1, NL-5621 BA Eindhoven (NL)**

(84) Benannte Vertragsstaaten: **BE CH FR GB IT LI NL SE**

(72) Erfinder: **Schwarz, Dieter, p/A INT. OCTROOIBUREAU B.V. Prof. Holstlaan 6, NL-5656 AA Eindhoven (NL)**
Erfinder: **Misner, Ralf, p/A INT. OCTROOIBUREAU B.V. Prof. Holstlaan 6, NL-5656 AA Eindhoven (NL)**
Erfinder: **Glasbergen, Johannes Wilhelmus, p/A INT. OCTROOIBUREAU B.V. Prof. Holstlaan 6, NL-5656 AA Eindhoven (NL)**

(74) Vertreter: **Van den Brom, Arend Albertus, INTERNATIONAAL OCTROOIBUREAU B.V. Prof. Holstlaan 6, NL-5656 AA Eindhoven (NL)**

Adaptiver Deltamodulator

Die Erfindung betrifft einen adaptiven Deltamodulator gemäß dem Oberbegriff des Anspruchs 1.

Ein idealer Deltamodulator erzeugt an seinem Ausgang eine periodische 0-1-Folge, wenn an seinem Eingang kein Signal anliegt. Bei einem realen Deltamodulator treten jedoch — unter anderem wegen der unvermeidbaren Toleranzen bei seiner Realisierung mit Halbleiterbausteinen — Abweichungen von der periodischen 0-1-Folge auf. Dadurch wird z. B. das Kanalruhegeräusch im decodierten Signal auf der Empfängerseite erhöht und die Taktrückgewinnung erschwert.

Zur Behebung dieser Nachteile wird in der US-A-4 142 066 bei der Codierung von Sprache durch einen beliebigen (adaptiven oder anderen) Deltamodulator vorgeschlagen, während der Sprachpausen das Ausgangssignal eines Generators zu übertragen, der eine periodische 0-1-Folge erzeugt. Zur Detektion der Sprachpausen ist ein Sprachdetektor vorgesehen, an dessen Eingang entweder das zu codierende Sprachsignal oder das deltacodierte Sprachsignal geführt wird und dessen Ausgangssignal einen Umschalter steuert. Nach dieser US-A-4 142 066 wird in ersterem Falle ein üblicher analoger Sprachdetektor oder ein weiterer Deltamodulator mit einem darauf folgenden digitalen Sprachdetektor und in letzterem Falle allein ein digitaler Sprachdetektor verwendet. In beiden Fällen erfordert jedoch die Realisierung des vorgeschlagenen Verfahrens zur Detektion der Sprachpausen einen erheblichen zusätzlichen Schaltungsaufwand.

Der Erfindung liegt die Aufgabe zugrunde, einen adaptiven Deltamodulator mit einer Dynamikregelung der eingangs erwähnten Art zu schaffen, der nur einen sehr geringen Schaltungsaufwand erfordert, um beim Auftreten von Signalpausen am Eingang einen Generator für eine periodische 0-1-Folge auf betriebssichere Weise an den Übertragungsweg zu schalten.

Diese Aufgabe wird durch die im Anspruch 1 gekennzeichneten Merkmale gelöst. Vorteilhafte Ausgestaltungen der Erfindungen sind in den Ansprüchen 2 und 3 angegeben.

Anhand der Zeichnung wird nachstehend eine Ausführungsform der Erfindung näher erläutert. Es zeigt

Fig. 1 einen adaptiven Deltamodulator, wie beispielsweise aus der DE-A1-2 849 001 oder der FR-A-2 189 941 bekannt,

Fig. 2 einen adaptiven Deltamodulator nach Fig. 1 mit den erfindungsgemäßen Verbesserungen.

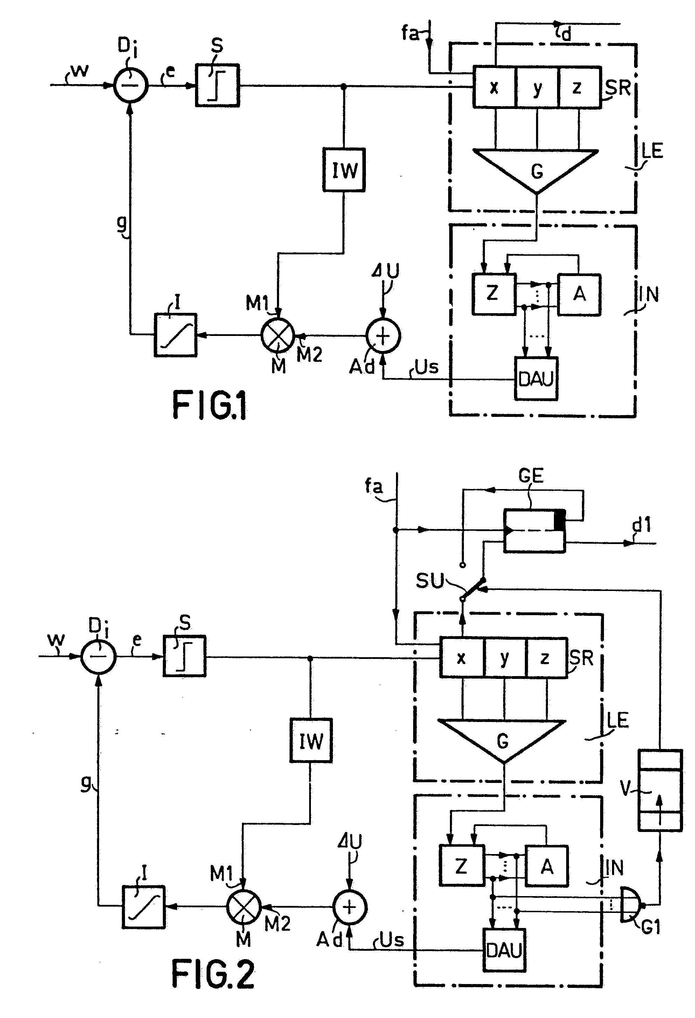

In Fig. 1 ist mit w das zu codierende, analoge Eingangssignal und mit d das deltacodierte Ausgangssignal des Modulators bezeichnet. Aus dem Ausgangssignal wird unter Verwendung einer logischen Schaltung LE, eines Filters IN, eines Addierers Ad, eines Multiplizierers M, eines Impulswandlers IW und eines Integrators I ein decodiertes Signal g erzeugt. Das Signal g wird zusammen mit dem Eingangssignal w einer Differenzstufe Di zugeführt. Ein Komparator S setzt das Vorzeichen der Differenz der Signale w und g in ein Binärsignal um, das mit der Frequenz fa abgetastet wird. Die Folge dieser Abtastwerte stellt das deltacodierte Signal d dar. Es wird an den Empfänger übertragen und gleichzeitig durch das sendeseitige Schieberegister SR der logischen Schaltung LE geschoben.

Der Ausgang einer jeden Stufe x, y und z des Schieberegisters SR ist mit je einem Eingang eines Gatters G verbunden. Dieses Gatter gibt nur dann einen Impuls an seinem Ausgang ab, wenn an allen drei Eingängen die gleichen Binärwerte anliegen. Die Ausgangsimpulse des Gatters G werden an das Filter IN weitergeleitet. Das Filter IN hat die Funktion, zu jedem Augenblick eine Ausgangsspannung Us zu erzeugen, die jener Anzahl von Impulsen proportional ist, die in einem zurückliegenden Zeitabschnitt einstellbarer Länge an den Eingang des Filters gegeben worden ist. Ein solches Filter kann entweder ein RC-Integrierglied sein oder — wie in Fig. 1 — dessen Nachbildung mit digitalen Bausteinen.

Die Ausgangsspannung Us des Filters IN wird durch den Addierer Ad zu einer Spannung $\Delta U$ hinzuaddiert und die Summe im Multiplizierer M mit dem Vorzeichen der Differenz der Signale w und g multipliziert. Den nötigen Vorzeichenimpuls erzeugt der Impulswandler IW.

Die Summe der Signale $\Delta U$ und Us wird als momentane Quantisierungseinheit bezeichnet. Sie ist die Größe, um die sich das decodierte Signal g zu den Taktzeitpunkten vergrößert oder verkleinert.

Wird das Eingangssignal w Null, so sollte bei einem idealen Deltamodulator das codierte Signal d aus einer periodischen 0-1-Folge bestehen. Bei einem realen Deltamodulator kann jedoch der Fall eintreten, daß zwei gleiche Binärwerte unmittelbar aufeinanderfolgen. Da sowohl bei einer periodischen 0-1-Folge als auch bei der angedeuteten Abweichung davon (aufgrund der Funktionsweise des Gatters G) keine Impulse an das Filter IN übertragen werden, strebt dieses mit der ihm eigenen Zeitkonstante einem Zustand zu, bei dem seine Ausgangsspannung Us auf den Wert Null geht.

Wird also beim Codieren die kleinste momentane Quantisierungseinheit verwendet oder tritt der dazu äquivalente Fall ein, daß die Ausgangsspannung Us des Filters IN Null ist, so ist das auch bei einem realen Deltamodulator ein Anzeichen dafür, daß am Eingang des Modulators Signalruhe eingetreten ist. Dieser Umstand wird bei der Erfindung zum Einschalten des Generators zur Erzeugung einer 0-1-Folge ausgenutzt.

Fig. 2 zeigt einen solchen Generator GE, der als Flip-Flop ausgebildet ist. Ein steuerbarer Umschalter SU verbindet entweder die Ausgangsklemme eines Modulators nach Fig. 1 oder den Q̄-Ausgang des Flip-Flops mit dem Dateneingang des Flip-Flops. An den Takteingang des Flip-Flops wird das auch nach Fig. 1 verwendete Taktsignal mit der Taktfrequenz fa gelegt. Steht der steuerbare Umschalter SU in der eingezeichneten Stellung, so stimmt das Ausgangssignal d1 des Modulators nach Fig. 2 bitweise mit dem Signal d nach Fig. 2 überein. Wird der steuerbare Umschalter SU jedoch aufgrund eines Steuerimpulses in seine andere Stellung gebracht, so ist das Flip-Flop rückgekoppelt und das Signal d1 besteht aus einer periodischen 0-1-Folge.

Den Steuerimpuls erhält der Umschalter SU genau dann, wenn die Ausgangsspannung Us des Filters IN den Wert Null annimmt. Schaltungstechnisch wäre das etwa durch einen weiteren Komparator zu realisieren, an dessen Eingang die Ausgangsspannung Us des Filters IN geführt wird und dessen Ausgangssignal auf den Steuereingang des Umschalters SU gegeben wird. Handelt es sich bei dem Filter IN jedoch um ein digitales Filter, wie z. B. die Fig. 1 und 2 zeigen, so bietet sich die Möglichkeit, die Folgen von Ungenauigkeiten, die sich bei der Digital-Analog-Umwandlung ergeben könnten, dadurch zu umgehen, daß sämtliche Binärwertspeicherplätze des Filters mit einem Gatter überprüft werden und daß dann — abhängig vom Prü-fungsergebnis — der Generator GE eingeschal-tet wird. Als Gatter zeigt die Fig. 2 ein ODER-Gatter G1 mit Negation am Ausgang. Es gibt eine binäre »1« ab, wenn an sämtlichen Eingängen eine binäre »0« anliegt. Mit dem Gatter G1 wird der Stand eines Zählers Z abgefragt, der zusammen mit einem Akkumulator A und einem Digital-Analog-Wandler DAU das Filter IN bildet. Handelt es sich bei dem Zähler Z um einen Synchronzähler, so ist kein gesondertes Gatter G1 notwendig, da der Zähler ohnehin ein Gatter enthält, mit dem alle Speicherplätze abgefragt werden.

Um das Einschalten des Generators GE bei sehr kurzen Pausen im Signal w zu verhindern, ist ein Verzögerungsglied V vorgesehen, das nur die Vorderflanke eines Impulses vom Gatter G1 verzögert. Ist z. B. eine Pause im Signal w kürzer als die eingestellte Verzögerung des Verzögerungsgliedes V, so wird überhaupt kein Impuls an den steuerbaren Umschalter SU weitergelei-tet. Ohne das Verzögerungsglied führt das codierte Signal auf der Empfangsseite zu einer »abgehackten« Sprache, wenn das zu codierende Signal w ein Sprachsignal ist.

## Patentansprüche

1. Adaptiver Deltamodulator, der zur Dynamikregelung einen Rückkopplungsweg mit einer das deltacodierte Signal verarbeitenden logischen Schaltung (LE) und einem darauf folgenden Filter (IN) enthält, wobei die Ausgangsspannung (Us) des Filters (IN) die momentane Quantisierungseinheit bestimmt, und der um einen Generator (GE) erweitert ist, der eine periodische 0-1-Folge erzeugt und dessen Ausgangssignal über einen durch einen Signalpausendetektor gesteuerten Umschalter (SU) anstelle des deltacodierten Signals übertragen werden kann, da-durch gekennzeichnet, daß der Signalpausende-tektor durch die logische Schaltung (LE) und das darauf folgende Filter (IN) im Rückkopplungsweg des Deltamodulators gebildet wird und die Ausgangsspannung (Us) des Filters (IN) den Umschalter (SU) derart steuert, daß die Übertragung der 0-1-Folge höchstens so lange erfolgt, wie diese Ausgangsspannung (Us) den Wert Null annimmt.

2. Adaptiver Deltamodulator nach Anspruch 1, dadurch gekennzeichnet, daß im Falle einer digi-talen Ausführung des Filters (IN) der Wert Null seiner Ausgangsspannung mit einem Gatter (G1) mit mehreren Eingängen dadurch festgestellt wird, daß jede für einen Binärwert vorgesehene Speichereinheit des Filters (IN) mit einem Eingang des Gatters (G1) verbunden ist.

3. Adaptiver Deltamodulator nach Anspruch 1 oder Anspruch 2, dadurch gekennzeichnet, daß ein Verzögerungsglied (V) vorgesehen ist, mit dem das Anschalten des Generators (GE) gegenüber dem Zeitpunkt, zu dem die Ausgangsspannung des Filters (IN) den Wert Null annimmt, verzögert wird.

## Claims

1. An adaptive delta modulator which, for the purpose of dynamic control, comprises a feedback path having a logic circuit (LE) for processing the delta coded signal and a subsequent filter (IN), the output voltage (Us) of the filter (IN) determining the instantaneous quantizing unit, and which further comprises a generator (GE) for producing a periodic 0-1 sequence and whose output signal can be transmitted instead of the delta coded signal through a switch (SU) controlled by a signal pause detector, characterized in that the signal pause detector is constituted by the logic circuit (LE) and the subsequent filter (IN) in the feedback path of the delta modulator and that the output voltage (Us) of the filter (IN) controls the switch (SU) in a way such that the transmission of the 0-1 sequence is effected for a period of time not exceeding the period of time in which this output voltage (Us) has zero value.

2. An adaptive delta modulator as claimed in Claim 1, characterized in that for a digitally implemented filter (IN) the zero value of its output voltage is detected by means of a gate (G1) having a plurality of inputs, each storage unit provided for a binary value in the filter (IN) being connected to a separate input of the gate (G1).

3. An adaptive delta modulator as claimed in Claim 1 or Claim 2, characterized in that a delay line (V) is provided by means of which switching-on of the generator (GE) is delayed relative to the instant at which the output voltage of the filter (IN) assumes zero value.

## Revendications

1. Modulateur delta adaptatif qui, pour la régulation de dynamique, comporte un trajet de rétrocouplage comportant un circuit logique (LE) traitant le signal codé delta, suivi d'un filtre (IN), la tension de sortie (Us) du filtre (IN) déterminant l'unité de quantification instantanée et qui est étendu par un générateur (GE) qui produit une séquence 0-1 périodique et dont le signal de sortie peut être transmis par l'intermédiaire d'un commutateur (SU), commandé par un détecteur de pauses des signaux, en lieu du signal codé delta, caractérisé en ce que le détecteur de pauses des signaux est formé par le circuit logique (LE) et par le filtre (IN) suivant dans le trajet de rétrocouplage du modulateur delta et la tension de sortie (Us) du filtre (IN) commande le commutateur (SU) d'une manière telle que la transmission de la séquence 0-1 se produise tout au plus aussi longtemps que cette tension de sortie (Us) prend la valeur zéro.

2. Modulateur delta adaptatif suivant la revendication 1, caractérisé ce que dans le cas où le filtre (IN) est un filtre numérique, la valeur zéro de sa tension de sortie est établie au moyen d'une porte (G1) à plusieurs entrées par le fait que chaque unité de stockage prévue pour une valeur binaire du filtre (IN) est connectée à une entrée de la porte (G1).

3. Modulateur delta adaptatif suivant la revendication 1 ou 2, caractérisé en ce qu'un élément à retard (V) est prévu au moyen duquel la mise en circuit du générateur (GE) est retardée par rapport au moment auquel la tension de sortie du filtre (IN) prend la valeur zéro.

FIG.1

FIG.2